# EUROPEAN PATENT APPLICATION

(11) **EP 2 485 264 A1**
(43) Date of publication of application: **08.08.2012**
(21) Application number: 10820198.9
(22) Date of filing: 06.05.2010
(51) Int. Cl.: H01L 31/04

(54) **PHOTOELECTRIC CONVERSION DEVICE**

(30) Priority: 29.09.2009 JP 2009224597
(71) Applicant: Mitsubishi Heavy Industries, Ltd., Tokyo 108-8215 (JP)
(72) Inventor: SAKAI, Satoshi, Tokyo 108-8215 (JP); KOBAYASHI, Yasuyuki, Tokyo 108-8215 (JP)
(74) Representative: Bongiovanni, Simone
(86) International application number: PCT/JP2010/057768
(87) International publication number: WO 2011/040078

(57) **Abstract**

A photovoltaic device comprising an intermediate contact layer for which the reflection characteristics have been optimized. The photovoltaic device (100) comprises a transparent electrode layer (2), which is disposed on a substrate (1) and has a textured structure on the surface opposite the substrate (1), a photovoltaic layer (3) composed of two electric power generation layers (91, 92), a back electrode layer (4), and an intermediate contact layer (5) disposed between the two electric power generation layers (91, 92), wherein the intermediate contact layer (5) comprises a titanium oxide film comprising mainly titanium oxide and a backside transparent conductive film comprising mainly a transparent conductive oxide, with the titanium oxide film disposed nearer the substrate (1), and the thickness of the titanium oxide film is a value that falls within a range defined as being from 65 to 110 nm inclusive when the thickness of the backside transparent conductive film is 5 nm, and similarly, from 65 to 95 nm inclusive when 10 nm, from 65 to 90 nm inclusive when 15 nm, from 60 to 85 nm inclusive when 20 nm, from 55 to 70 nm inclusive when 25 nm, and from 55 to 65 nm inclusive when 30 nm.

## Description

### Technical Field

The present invention relates to a photovoltaic device, and relates particularly to a thin-film solar cell in which the electric power generation layer is formed by deposition.

### Background Art

One known example of a photovoltaic device that converts the energy from sunlight into electrical energy is a thin-film silicon-based solar cell comprising a photovoltaic layer formed by using a plasma-enhanced CVD method or the like to deposit thin films of a p-type silicon-based semiconductor (p-layer), an i-type silicon-based semiconductor (i-layer) and an n-type silicon-based semiconductor (n-layer). Advantages of thin-film silicon-based solar cells include the comparative ease with which the surface area can be increased, and the fact that the film thickness is approximately 1/100th that of a crystalline solar cell, meaning minimal material is required. As a result, thin-film silicon-based solar cells can be produced at lower cost than crystalline solar cells.

In this technical field, improving the conversion efficiency is a very important task, and tandem solar cells have been proposed that have a photovoltaic layer comprising amorphous silicon layers and crystalline silicon layers stacked in that order as electric power generation layers, with the amorphous silicon layers nearer the substrate. In tandem solar cells, an intermediate contact layer composed of a transparent conductive film is inserted between the amorphous silicon layers and the crystalline silicon layers for the purposes of inhibiting the mutual diffusion of dopants between the layers and adjusting the light intensity distribution. One layer of a transparent conductive film of Ga-doped ZnO (GZO) or the like is generally provided as the intermediate contact layer. However, with a single-layer intermediate contact layer, a problem arises in that the amount of incident light entering the crystalline silicon layers is dramatically reduced. Even if the refractive index (the material of the intermediate contact layer) and the thickness are altered, a single-layer intermediate contact layer having optimal selective reflection properties cannot be obtained.

Patent Literature (PTL) 1 discloses a stacked solar cell wherein an intermediate layer composed of a multilayer film prepared by alternately stacking two or more materials is provided. In this intermediate layer, a transparent conductive film is used as the first film and a silicon or silicon-carbon containing conductive impurities is used as the second film.

### Citation List

### Patent Literature

{PTL 1} Japanese Unexamined Patent Application, Publication No. 2001-308354 (claim 1, claim 5, claim 7, and paragraphs [0022] to [0030])

### Summary of Invention

### Technical Problem

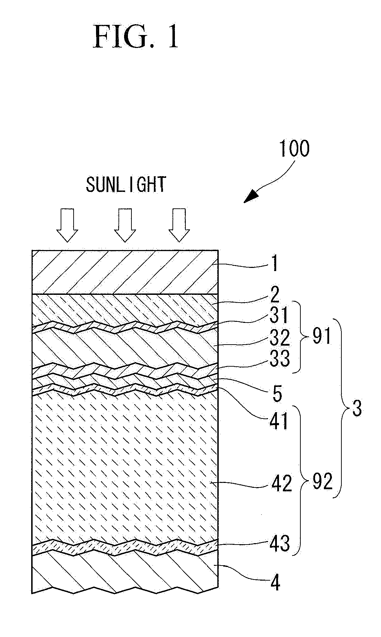

In PTL 1, as illustrated in Fig. 1 of the same publication, a solar cell model having stacked flat films (a parallel plate model) is used to calculate the selective reflectance of a multilayer structure. However, in an actual solar cell, the surface of a transparent electrode layer formed by deposition has an uneven structure (a textured structure). As a result of this textured structure of the transparent electrode layer surface, the surfaces of the photovoltaic layer and the intermediate contact layer are also imparted with a textured structure. In order to achieve an optimal structure for the intermediate contact layer, the effects of incident light scattering caused by the above textured structure must also be taken into consideration.

The present invention has an object of providing a photovoltaic device comprising an intermediate contact layer for which the reflection characteristics have been optimized.

### Solution to Problem

The present invention provides a photovoltaic device comprising a transparent electrode layer, which is disposed on a substrate and has a textured structure on the surface opposite the substrate, a photovoltaic layer composed of two electric power generation layers disposed on the transparent electrode layer, a back electrode layer disposed on the photovoltaic layer, and an intermediate contact layer disposed between the two electric power generation layers, wherein the intermediate contact layer comprises a titanium oxide film comprising mainly titanium oxide and a backside transparent conductive film comprising mainly a transparent conductive oxide, with the titanium oxide film disposed nearer the substrate, and the thickness of the titanium oxide film is a value that falls within a range defined by limits of not less than 65 nm and not more than 110 nm when the thickness of the backside transparent conductive film is 5 nm, not less than 65 nm and not more than 95 nm when the thickness of the backside transparent conductive film is 10 nm, not less than 65 nm and not more than 90 nm when the thickness of the backside transparent conductive film is 15 nm, not less than 60 nm and not more than 85 nm when the thickness of the backside transparent conductive film is 20 nm, not less than 55 nm and not more than 70 nm when the thickness of the backside transparent conductive film is 25 nm, and not less than 55 nm and not more than 65 nm when the thickness of the backside transparent conductive film is 30 nm.

If a single layer of a film comprising mainly titanium oxide (TiO₂) is provided as an intermediate contact layer, then the amount of incident light entering the electric power generation layer on the opposite side to the substrate can be increased. However, if titanium oxide is exposed to a hydrogen plasma, then oxygen loss occurs, causing coloration problems. Further, because titanium oxide has low conductivity, the electrical contact properties with the electric power generation layer tend to be poor. Accordingly, in the present invention, a backside transparent conductive film comprising mainly a transparent conductive oxide is provided on the titanium oxide film, and this backside transparent conductive film functions as a plasma protective layer for the titanium oxide film and also improves the electrical contact properties.
Providing the backside transparent conductive film as an intermediate contact layer generates optical loss. Investigation of the optimal thickness values for each of the films of an intermediate contact layer having the structure described above, for a tandem photovoltaic device comprising a transparent electrode layer having a textured structure on the surface, revealed that the optimal thickness values were very different from the optimal thickness values predicted by a parallel plate model. By providing an intermediate contact layer comprising a titanium oxide film and a backside transparent conductive film having thickness values that satisfy the ranges prescribed in the present invention, the amount of incident light entering the electric power generation layer provided on the back side of the device can be increased, meaning the amount of electric current generated by the backside electric power generation layer can also be increased. As a result, the amount of electric current generated by the overall tandem photovoltaic device can be increased, enabling the production of a high-output photovoltaic device.

In the present invention described above, the intermediate contact layer preferably further comprises a substrate-side transparent conductive film comprising mainly a transparent conductive oxide on the substrate-side surface of the titanium oxide film. In this case, the thickness of the substrate-side transparent conductive film is preferably not less than 5 nm and not more than 30 nm.

By providing a substrate-side transparent conductive film and making the intermediate contact layer a three-layer structure, optical loss can be suppressed, and the electrical contact properties between the substrate-side electric power generation layer and the intermediate contact layer can be improved. The substrate-side transparent conductive film does not function as a plasma protective layer for the titanium oxide film, and therefore need not necessarily have the same thickness as the backside transparent conductive film in relation to the titanium oxide film.

In the present invention described above, the haze ratio of the substrate having the transparent electrode layer provided thereon is preferably not less than 20% and not more than 30%.
By providing a transparent electrode layer with the above haze ratio, light scattering causes an increase in the length of the light path of the incident light. Further, by ensuring a haze ratio within the above range, favorable coverability can be achieved for each of the layers formed on the transparent electrode layer.

### Advantageous Effects of Invention

The photovoltaic device of the present invention provides a titanium oxide film as an intermediate contact layer, and therefore increases the amount of incident light entering the backside electric power generation layer. Further, by also providing a backside transparent conductive film as an intermediate contact layer, favorable electrical contact properties and good plasma resistance for the titanium oxide film can be ensured. Furthermore, the thickness of each film within the intermediate contact layer is determined with due consideration of the textured shape of the transparent electrode layer surface, so as to maximize the amount of power generated in the photovoltaic layer. Accordingly, a high-output photovoltaic device is obtained.

### Brief Description of Drawings

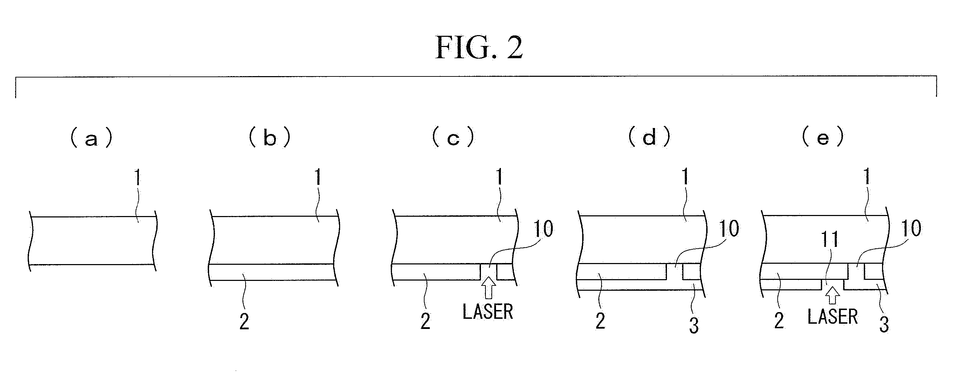

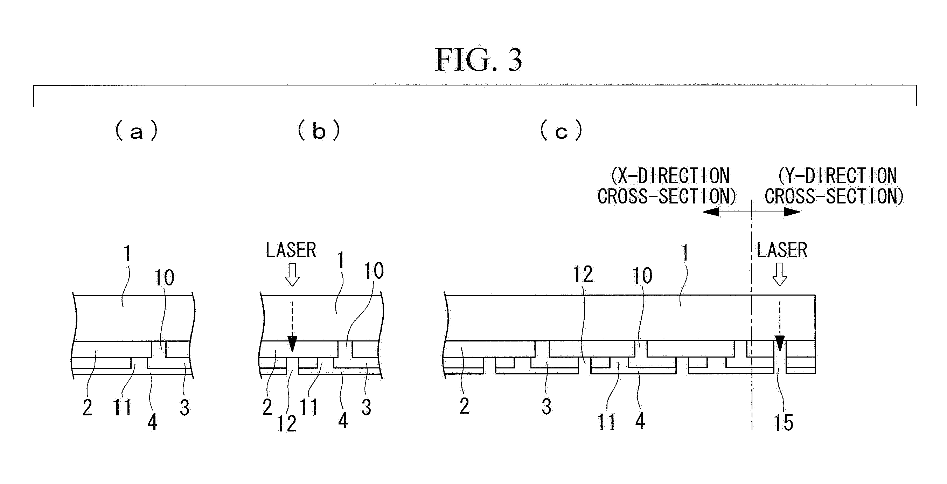

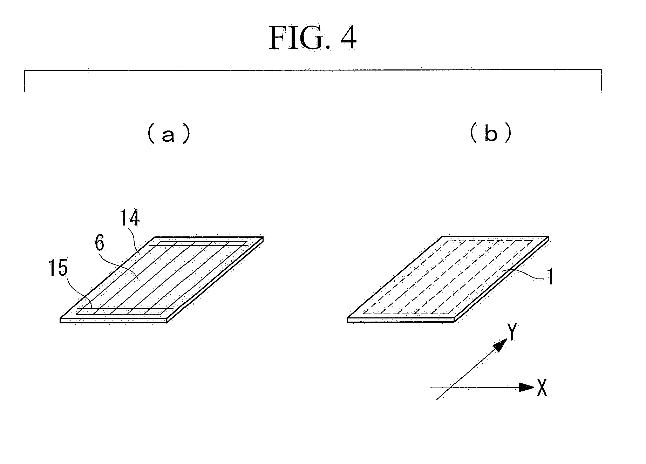

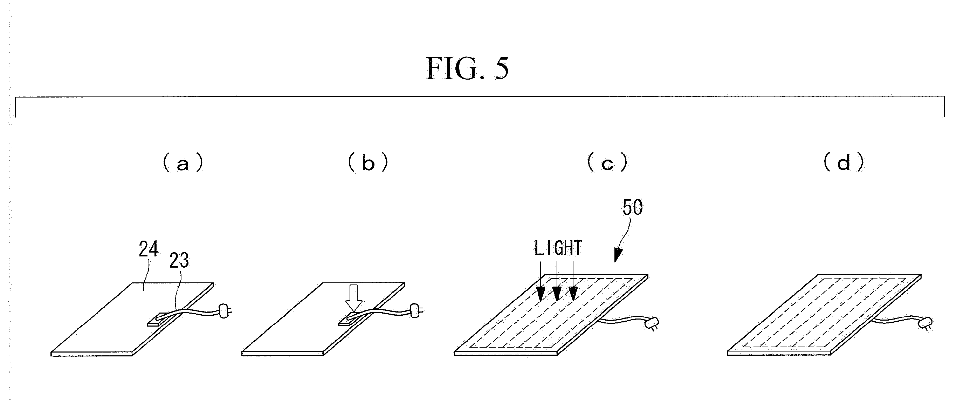

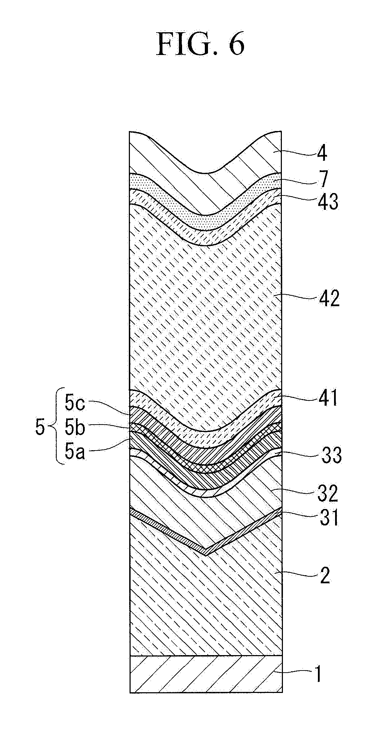

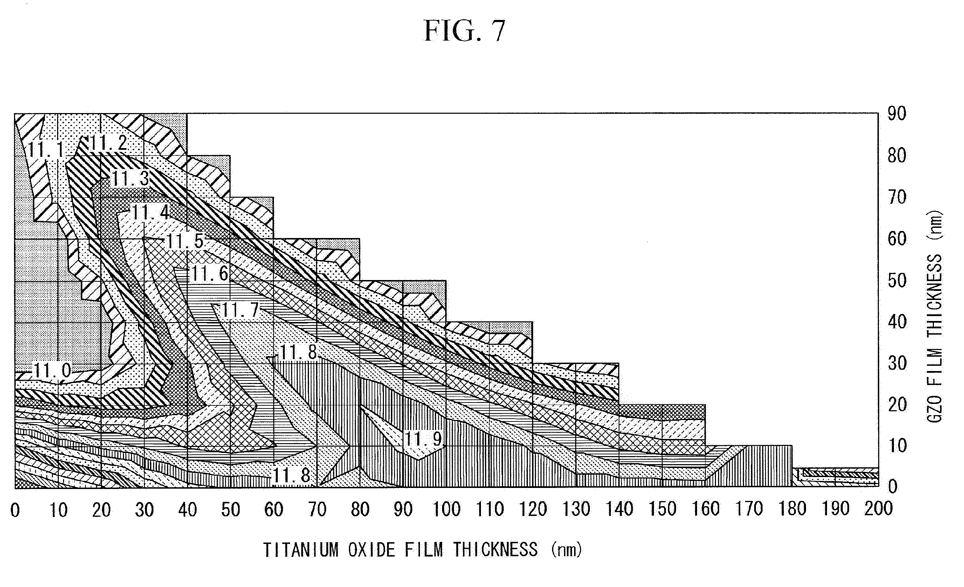

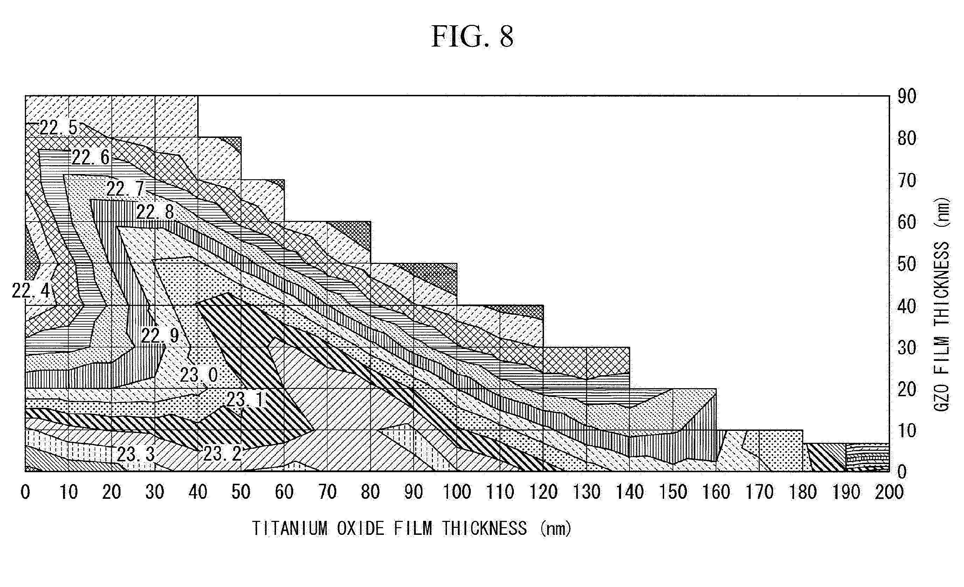

{Fig. 1} A schematic view illustrating the structure of a photovoltaic device according to the present invention.
{Fig. 2} A schematic illustration describing one embodiment for producing a solar cell panel representing a photovoltaic device according to the present invention.
{Fig. 3} A schematic illustration describing one embodiment for producing a solar cell panel representing a photovoltaic device according to the present invention.
{Fig. 4} A schematic illustration describing one embodiment for producing a solar cell panel representing a photovoltaic device according to the present invention.
{Fig. 5} A schematic illustration describing one embodiment for producing a solar cell panel representing a photovoltaic device according to the present invention.
{Fig. 6} A structural model of a tandem solar cell.
{Fig. 7} A distribution diagram for a tandem solar cell having a transparent electrode layer haze ratio of 20%, illustrating the sum of the electric current generated in the first cell layer and the electric current generated in the second cell layer, relative to the thickness of each layer within the intermediate contact layer.
{Fig. 8} A distribution diagram for a tandem solar cell having a transparent electrode layer haze ratio of 20%, illustrating the electric current generated in the second cell layer relative to the thickness of each layer within the intermediate contact layer.

### Description of Embodiments

Fig. 1 is a schematic view illustrating the structure of a photovoltaic device according to the present invention. A photovoltaic device 100 is a tandem silicon-based solar cell, and comprises a substrate 1, a transparent electrode layer 2, a photovoltaic layer 3 comprising a first cell layer 91 (amorphous silicon-based) and a second cell layer 92 (crystalline silicon-based) as electric power generation layers, an intermediate contact layer 5, and a back electrode layer 4. Here, the term "silicon-based" is a generic term that includes silicon (Si), silicon carbide (SiC) and silicon germanium (SiGe). Further, the term "crystalline silicon-based" describes a silicon system other than an amorphous silicon system, and includes both microcrystalline silicon systems and polycrystalline silicon systems.

A process for producing a photovoltaic device according to the present embodiment is described below, using the production steps for a solar cell panel as an example. Fig. 2 to Fig. 5 are schematic views illustrating the process for producing a solar cell panel according to this embodiment.

### (1) Fig. 2(a)

A soda float glass substrate (for example with dimensions of 1.4 m × 1.1 m × thickness: 3.5 to 4.5 mm) is used as the substrate 1. The edges of the substrate are preferably subjected to corner chamfering or R-face chamfering to prevent damage caused by thermal stress or impacts or the like.

### (2) Fig. 2(b)

A transparent electrode film comprising mainly tin oxide (SnO₂) and having a film thickness of approximately not less than 500 nm and not more than 800 nm is deposited as the transparent electrode layer 2, using a thermal CVD apparatus at a temperature of approximately 500°C. During this deposition, a texture (uneven structure) having suitable asperity is formed on the surface of the transparent electrode film. In this embodiment, the textured structure is formed such that the substrate with the transparent electrode layer formed thereon has a haze ratio of not less than 20% and not more than 30%.
In addition to the transparent electrode film, the transparent electrode layer 2 may also include an alkali barrier film (not shown in the figure) formed between the substrate 1 and the transparent electrode film. The alkali barrier film is formed using a thermal CVD apparatus at a temperature of approximately 500°C to deposit a silicon oxide film (SiO₂) having a film thickness of 50 nm to 150 nm.

### (3) Fig. 2(c)

Subsequently, the substrate 1 is mounted on an X-Y table, and the first harmonic of a YAG laser (1064 nm) is irradiated onto the surface of the transparent electrode film, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

### (4) Fig. 2(d)

Using a plasma-enhanced CVD apparatus, a p-layer, an i-layer and an n-layer, each composed of a thin film of amorphous silicon, are deposited as the first cell layer 91. Using SiH₄ gas and H₂ gas as the main raw materials, and under conditions including a reduced pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in that order, on the transparent electrode layer 2, with the p-layer closest to the surface from which incident sunlight enters. The amorphous silicon p-layer 31 comprises mainly amorphous B-doped silicon, and has a thickness of not less than 10 nm and not more than 30 nm. The amorphous silicon i-layer 32 has a thickness of not less than 200 nm and not more than 350 nm. The amorphous silicon n-layer 33 comprises mainly P-doped silicon in which microcrystalline silicon is incorporated within amorphous silicon, and has a thickness of not less than 30 nm and not more than 50 nm. A buffer layer may be provided between the amorphous silicon p-layer 31 and the amorphous silicon i-layer 32 in order to improve the interface properties.

An intermediate contact layer 5 that functions as a semi-reflective film for improving the contact properties and achieving electrical current consistency is provided between the first cell layer 91 and the second cell layer 92. In the present embodiment, the intermediate contact layer 5 includes a titanium oxide film comprising mainly titanium oxide, and a backside transparent conductive film comprising mainly a transparent conductive oxide, with the titanium oxide film disposed nearer the substrate. Examples of the transparent conductive oxide include Ga-doped ZnO (GZO), Al-doped ZnO (AZO) and ITO. A GZO film used as the backside transparent conductive film is deposited using a sputtering apparatus with a Ga-doped ZnO sintered body as the target.

In order to suppress optical loss, the backside transparent conductive film is preferably as thin as possible. On the other hand, in order to ensure favorable electrical contact properties and satisfactory functionality as a plasma protective layer for the titanium oxide film, the coverability relative to the titanium oxide film must be favorable. In view of the above requirements, the thickness of the backside transparent conductive film is preferably not less than 5 nm, and more preferably 10 nm or greater.

When the backside transparent conductive film satisfies the thickness range mentioned above, the range of thickness values for the titanium oxide film that enables maximization of the amount of electric current generated by the overall photovoltaic layer 3 is a value that falls within a range defined by limits of not less than 65 nm and not more than 110 nm when the thickness of the backside transparent conductive film is 5 nm, not less than 65 nm and not more than 95 nm when the thickness of the backside transparent conductive film is 10 nm, not less than 65 nm and not more than 90 nm when the thickness of the backside transparent conductive film is 15 nm, not less than 60 nm and not more than 85 nm when the thickness of the backside transparent conductive film is 20 nm, not less than 55 nm and not more than 70 nm when the thickness of the backside transparent conductive film is 25 nm, and not less than 55 nm and not more than 65 nm when the thickness of the backside transparent conductive film is 30 nm.

The intermediate contact layer 5 of the present embodiment may further comprise a substrate-side transparent conductive film comprising mainly a transparent conductive oxide on the substrate side of the titanium oxide film. This substrate-side transparent conductive film may be deposited using the same method as the backside transparent electrode film. In consideration of optical loss and coating properties, the thickness of the substrate-side transparent conductive film is preferably not less than 5 nm and not more than 30 nm, and more preferably not less than 10 nm and not more than 30 nm. The substrate-side transparent conductive film need not necessarily be the same thickness as the backside transparent conductive film.

Next, using a plasma-enhanced CVD apparatus, and under conditions including a reduced pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited sequentially as the second cell layer 92 on top of the first cell layer 91. The crystalline silicon p-layer 41 comprises mainly B-doped microcrystalline silicon, and has a thickness of not less than 10 nm and not more than 50 nm. The crystalline silicon i-layer 42 comprises mainly microcrystalline silicon, and has a thickness of not less than 1.2 µm and not more than 3.0 µm. The crystalline silicon n-layer 43 comprises mainly P-doped microcrystalline silicon, and has a thickness of not less than 20 nm and not more than 50 nm.

During formation of the i-layer comprising mainly microcrystalline silicon using a plasma-enhanced CVD method, a distance d between the plasma discharge electrode and the surface of the substrate 1 is preferably not less than 3 mm and not more than 10 mm. If this distance d is less than 3 mm, then the precision of the various structural components within the film deposition chamber required for processing large substrates means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

### (5) Fig. 2(e)

The substrate 1 is mounted on an X-Y table, and the second harmonic of a laser diode excited YAG laser (532 nm) is irradiated onto the surface of the photovoltaic layer 3, as shown by the arrow in the figure. With the pulse oscillation set to 10 kHz to 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1, and in this case, because the high vapor pressure generated by the energy absorbed by the amorphous silicon-based first cell layer of the photovoltaic layer 3 can be utilized in etching the photovoltaic layer 3, more stable laser etching processing can be performed. The position of the laser etching line is determined with due consideration of positioning tolerances, so as not to overlap with the previously formed etching line.

### (6) Fig. 3(a)

Using a sputtering apparatus, an Ag film and a Ti film are deposited as the back electrode layer 4, under a reduced pressure atmosphere and at a deposition temperature of approximately 150°C to 200°C. In this embodiment, an Ag film having a thickness of not less than 150 nm and not more than 500 nm, and a highly corrosion-resistant Ti film having a thickness of not less than 10 nm and not more than 20 nm which acts as a protective film for the Ag film are stacked in that order. Alternatively, the back electrode layer 4 may be formed as a stacked structure composed of a Ag film having a thickness of 25 nm to 100 nm, and an Al film having a thickness of 15 nm to 500 nm. In order to reduce the contact resistance between the crystalline silicon n-layer 43 and the back electrode layer 4 and improve the reflectance, a sputtering apparatus may be used to deposit a GZO (Ga-doped ZnO) film with a thickness of not less than 50 nm and not more than 100 nm as a backside transparent electrode layer between the photovoltaic layer 3 and the back electrode layer 4.

### (7) Fig. 3(b)

The substrate 1 is mounted on an X-Y table, and the second harmonic of a laser diode excited YAG laser (532 nm) is irradiated through the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) Fig. 3(c) and Fig. 4(a)

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated through the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in Fig. 3(c). Fig. 3(c) represents an X-direction cross-sectional view cut along the direction of the series connection of the photovoltaic layer 3, and therefore the location in the figure where the insulation slot 15 is formed should actually appear as a peripheral film removed region 14 in which the back electrode layer 4, the photovoltaic layer 3 and the transparent electrode layer 2 have been removed by film polishing (see Fig. 4(a)), but in order to facilitate description of the processing of the edges of the substrate 1, this location in the figure represents a Y-direction cross-sectional view, so that the formed insulation slot represents an X-direction insulation slot 15. A Y-direction insulation slot need not be provided at this point, because a film surface polishing and removal treatment is conducted on the peripheral film removal regions of the substrate 1 in a later step.

Completing the etching of the insulation slot 15 at a position 5 mm to 15 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YVO4 laser or fiber laser or the like may also be used in a similar manner.

### (9) Fig. 4 (a: view from solar cell film surface side, b: view from substrate side of light incident surface)

In order to ensure favorable adhesion and sealing of a backing sheet 24 via EVA or the like in a subsequent step, the stacked films around the periphery of the substrate 1 (in a peripheral film removal region 14), which tend to be uneven and prone to peeling, are removed to form a peripheral film removed region 14. During removal of the films from a region that is 5 to 20 mm from the edge around the entire periphery of the substrate 1, grinding or blast polishing or the like is used to remove the back electrode layer 4, the photovoltaic layer 3 and the transparent electrode layer 2 from a region that is closer to the substrate edge in the X direction than the insulation slot 15 provided in the above step of Fig. 3(c), and closer to the substrate edge in the Y direction than the slot 10 provided near the substrate edge.
Grinding debris or abrasive grains are removed by washing the substrate 1.

### (10) Fig. 5(a) (b)

An attachment portion for a terminal box 23 is prepared by providing an open through-window in the backing sheet 24 to expose a collecting plate. A plurality of layers of an insulating material are provided in this open through-window portion in order to prevent external moisture and the like entering the solar cell module.
Processing is conducted so as to enable current collection, using a copper foil, from the series-connected solar cell electric power generation cell at one end, and the solar cell electric power generation cell at the other end, in order to enable electric power to be extracted from the terminal box 23 on the rear surface of the solar cell panel. In order to prevent short circuits between the copper foil and the various portions, an insulating sheet that is wider than the width of the copper foil is provided.
Following arrangement of the collecting copper foil and the like at predetermined positions, the entire solar cell module 6 is covered with a sheet of an adhesive filling material such as EVA (ethylene-vinyl acetate copolymer), which is arranged so as not to protrude beyond the substrate 1.
A backing sheet 24 with a superior waterproofing effect is then positioned on top of the EVA. In this embodiment, in order to achieve a superior waterproofing and moisture-proofing effect, the backing sheet 24 is formed as a three-layer structure comprising a PET sheet, an Al foil and a PET sheet.
The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

### (11) Fig. 5(a)

The terminal box 23 is attached to the back of the solar cell module 6 using an adhesive.

### (12) Fig. 5(b)

The copper foil and an output cable from the terminal box 23 are connected using solder or the like, and the interior of the terminal box 23 is filled and sealed with a sealant (a potting material). This completes the production of the solar cell panel 50.

### (13) Fig. 5(c)

The solar cell panel 50 formed via the steps up to and including Fig. 5(b) is then subjected to an electric power generation test, as well as other tests for evaluating specific performance factors. The electric power generation test is conducted using a solar simulator that emits a standard sunlight of AM 1.5 (1,000 W/m²).

### (14) Fig. 5(d)

In tandem with the electric power generation test (Fig. 5(c)), a variety of specific performance factors including the external appearance are evaluated.

### Examples

### Example 1

An optical analysis calculation for a tandem solar cell of the structural model illustrated in Fig. 6 was performed using a FDTD (Finite Difference Time Domain) method for the case where incident light enters the solar cell from the side of the glass substrate 1, and a light absorption spectrum was determined for each layer. The value calculated by integrating the product obtained by multiplying the absorption spectrum and the sunlight spectrum (AM 1.5) was used as the electric current. The size of one pixel of the structural model was 10 nm. The structural model was a pseudo two-dimensional model, and optical analysis calculations were performed for light of two polarization directions (p-polarized light and s-polarized light), with the average value of the two results being used as the solution. p-polarized light refers to light in which the electric field vector is parallel to the surface of the page in Fig. 6, whereas s-polarized light refers to light in which the electric field vector is perpendicular to the surface of the page in Fig. 6. The electric current within the i-layer 32 of the first cell layer was recorded as the current generated by the first cell layer. Similarly, the electric current within the i-layer 42 of the second cell layer was recorded as the current generated by the second cell layer.

The composition and thickness of each of the layers shown in Fig. 6 were set as follows.
Glass substrate 1 (Corning #1737): semi-infinite medium
Transparent electrode layer 2 (F-doped SnO₂ film): 700 nm First cell layer
Amorphous silicon p-layer 31: 10 nm
Amorphous silicon i-layer 32: 200 nm
Crystalline silicon n-layer 33: 30 nm
Intermediate contact layer 5
Substrate-side transparent conductive film 5a (GZO film)
Titanium oxide film 5b
Backside transparent conductive film 5c (GZO film)

### Second cell layer

Crystalline silicon p-layer 41: 30 nm
Crystalline silicon i-layer 42: 1.5 µm
Crystalline silicon n-layer 43: 30 nm
Backside transparent electrode layer 7 (GZO film): 80 nm
Back electrode layer 4 (Ag film): 160 nm
The haze ratio of the transparent electrode layer (the substrate having the transparent electrode layer provided thereon) was 20%.

The pitch of the textured structure (the distance between the peaks of adjacent protrusions) within the transparent electrode layer 2 in the structural model of Fig. 6 was 0.6 µm, and the inclination angle was 30°. The pitch and the inclination angle were determined by performing an AFM shape analysis of the surface shape of a transparent electrode layer-bearing glass substrate having a haze ratio of 20% as measured by a haze meter, and analyzing the three dimensional shape data.
The structural model assumed that the first cell p-layer 31 had a similar surface shape to that of the transparent electrode layer 2. A shape model for the first cell i-layer 32 was determined by performing an AFM shape analysis of the surface shape of the i-layer 32, and analyzing the three dimensional shape data. The structural model assumed that the first cell n-layer 33 had a similar surface shape to that of the i-layer 32.
The structural model assumed that the intermediate contact layer 5 had a similar surface shape to that of the first cell n-layer 33. The substrate-side transparent conductive film 5a and the backside transparent conductive film 5c were calculated as having the same thickness.
The structural model assumed that the second cell p-layer 41 had a similar surface shape to that of the backside transparent conductive film 5c of the intermediate contact layer 5. A shape model for the second cell i-layer 42 was determined by performing an AFM shape analysis of the surface shape of the i-layer 42, and analyzing the three dimensional shape data. The structural model assumed that the second cell n-layer 43 had a similar surface shape to that of the i-layer 42.
The structural model assumed that the backside transparent electrode layer 7 had a similar surface shape to that of the second cell n-layer 43. The structural model also assumed that the back electrode layer 4 had a similar surface shape to that of the backside transparent electrode layer 7.

Fig. 7 is a distribution diagram for the tandem solar cell, and illustrates the sum of the electric current generated in the first cell layer and the electric current generated in the second cell layer, relative to the thickness of the titanium oxide film and the thickness of one of the GZO films (either the substrate-side transparent conductive film or the backside transparent conductive film). Fig. 8 is a distribution diagram illustrating the electric current generated in the second cell layer. In Fig. 7 and Fig. 8, the horizontal axis represents the thickness of the titanium oxide film, the vertical axis represents the thickness of the GZO film, and the numbers within the figure represent short-circuit current values (units: mA/cm²) at the illustrated boundary lines.

In Fig. 7, the short-circuit current when no intermediate contact layer was provided (titanium oxide film: 0 nm, GZO film: 0 nm) was within a range from 23.5 to 23.6 mA/cm². When a single layer of a GZO film is provided as the intermediate contact layer, the thickness of the film is typically within a range from 30 to 180 nm (15 to 90 nm for each GZO film). The short-circuit current in the case of a single layer of a GZO film was within a range from 22.3 to 22.6 mA/cm². From Fig. 7 it is evident that in the region where the thickness of the titanium oxide film is within a range from 60 to 110 nm and the thickness of the GZO film is within a range from 0 to 35 nm, any reduction in the short-circuit current is suppressed even when an intermediate contact layer is provided. As illustrated in Fig. 8, the electric current generated by the second cell layer within the above-mentioned thickness region is significantly greater than the current generated when an intermediate contact layer composed of a single layer of a GZO film is provided. This results indicates that by employing thickness values that satisfy the above thickness region, the amount of incident light entering the second cell layer can be increased.
In this manner, provided the thicknesses of the titanium oxide film and the GZO film are selected so that they satisfy the above thickness region, the amount of incident light entering the second cell layer can be increased, and the short-circuit current of the overall cell can be increased.

For a parallel plate model tandem solar cell, using the structure and thickness values described above, determination of the thickness for the three-layer intermediate contact layer that yields the highest short-circuit current, by optical thin film interference calculations based on the Fresnel equations, revealed a GZO film thickness (the first and third layers) of 80 nm and a titanium oxide film thickness (second layer) of 30 nm. However, this combination of film thicknesses corresponds with a low short-circuit current region in Fig. 7, and a low electric current generation region for the second cell layer in Fig. 8. In this manner, the optimal thickness value for each of the layers differed significantly between the textured structure model used in the present example and the parallel plate model. By using the model of the present example, which is closer to an actual solar cell, film thickness values can be determined for an intermediate contact layer that yields a superior short-circuit current.

For a tandem solar cell provided with an intermediate contact layer composed of a GZO film single layer (thickness: 180 nm), an increase in the short-circuit current of 0.3% or greater represents an industrially significant increase. Based on Fig. 7, for the case where the haze ratio of the transparent electrode layer is 20%, if due consideration is given to the plasma resistance of the titanium oxide film and the electrical contact properties, then the region that yields an increase in the short-circuit current of 0.3% or greater is represented by the combination of film thickness values shown in Table 1. A combination of a titanium oxide film thickness of 80 to 90 nm and a GZO film thickness of 10 to 20 nm is particularly preferred, because the electric current generated in the second cell layer is large, and favorable plasma resistance and electrical contact properties can be obtained.

**Table 1**

| GZO film thickness (nm) | Titanium oxide film thickness (nm) | |
|---|---|---|
| 5 | 65 | 110 |
| 10 | 65 | 95 |
| 15 | 65 | 90 |
| 20 | 60 | 85 |
| 25 | 55 | 70 |
| 30 | 55 | 65 |

In the case where an intermediate contact layer having a two-layer structure (titanium oxide film / backside transparent conductive film) is provided, the short-circuit current can be increased by using substantially the same thickness values for the titanium oxide film and the GZO film as those of the present example.

### Example 2

The structure and thickness of each of the layers in Example 2 were the same as those in Example 1.
In Example 2, the haze ratio of the transparent electrode layer (the substrate having the transparent electrode layer provided thereon) in the structural model illustrated in Fig. 6 was 30%, the pitch of the textured structure of the transparent electrode layer 2 was 1 µm, and the inclination angle was 30°. A structural model was used in which the surface shapes of the first cell i-layer 32 and the second cell i-layer 42 were determined from the results of AFM shape analysis.
In Example 2, optical analysis calculations were used to prepare a short-circuit current distribution diagram similar to that of Example 1. In Example 2, the thickness region that yielded an increase in the short-circuit current tended to shift slightly towards a thinner titanium oxide film compared with the thickness region that yielded an increase in the short-circuit current in Example 1.
In this manner, even when the haze ratio was increased from 20% to 30%, the shift in the thickness region that yielded an increase in the short-circuit current was slight. Accordingly, it can be claimed that, even for a haze ratio of 30%, the short-circuit current can be increased within the thickness region shown in Table 1.

### Reference Signs List

- 1: Substrate
- 2: Transparent electrode layer
- 3: Photovoltaic layer
- 4: Back electrode layer
- 5: Intermediate contact layer
- 5a: Substrate-side transparent conductive film
- 5b: Titanium oxide film
- 5c: Backside transparent conductive film
- 6: Solar cell module
- 7: Backside transparent electrode layer
- 31: Amorphous silicon p-layer
- 32: Amorphous silicon i-layer
- 33: Amorphous silicon n-layer
- 41: Crystalline silicon p-layer
- 42: Crystalline silicon i-layer
- 43: Crystalline silicon n-layer
- 91: First cell layer
- 92: Second cell layer
- 100: Photovoltaic device

## Claims

1. A photovoltaic device comprising a transparent electrode layer, which is disposed on a substrate and has a textured structure on a surface opposite the substrate, a photovoltaic layer composed of two electric power generation layers disposed on the transparent electrode layer, a back electrode layer disposed on the photovoltaic layer, and an intermediate contact layer disposed between the two electric power generation layers, wherein
the intermediate contact layer comprises a titanium oxide film comprising mainly titanium oxide and a backside transparent conductive film comprising mainly a transparent conductive oxide, with the titanium oxide film disposed nearer the substrate, and
a thickness of the titanium oxide film is a value that falls within a range defined by limits of:
not less than 65 nm and not more than 110 nm when a thickness of the backside transparent conductive film is 5 nm,
not less than 65 nm and not more than 95 nm when a thickness of the backside transparent conductive film is 10 nm,
not less than 65 nm and not more than 90 nm when a thickness of the backside transparent conductive film is 15 nm,
not less than 60 nm and not more than 85 nm when a thickness of the backside transparent conductive film is 20 nm,
not less than 55 nm and not more than 70 nm when a thickness of the backside transparent conductive film is 25 nm, and
not less than 55 nm and not more than 65 nm when a thickness of the backside transparent conductive film is 30 nm.

2. The photovoltaic device according to Claim 1, wherein the intermediate contact layer further comprises a substrate-side transparent conductive film comprising mainly a transparent conductive oxide on a substrate-side surface of the titanium oxide film.

3. The photovoltaic device according to Claim 2, wherein a thickness of the substrate-side transparent conductive film is not less than 5 nm and not more than 30 nm.

4. The photovoltaic device according to any one of Claims 1 to 3, wherein a haze ratio of the substrate having the transparent electrode layer provided thereon is not less than 20% and not more than 30%.
